# EUROPEAN PATENT APPLICATION

(11) **EP 4 269 005 A1**
(43) Date of publication of application: **01.11.2023**
(21) Application number: 21910523.6
(22) Date of filing: 15.12.2021
(51) Int. Cl.: B23B 27/14, B23B 51/00, C23C 14/06

(54) **SURFACE-COATED CUTTING TOOL**

(30) Priority: 22.12.2020 JP 2020212386
(71) Applicant: Mitsubishi Materials Corporation, Tokyo 100-8117 (JP)
(72) Inventor: SATO, Shun, Tokyo 100-8117 (JP); SUGAWARA, Yuto, Tokyo 100-8117 (JP)
(74) Representative: Gille Hrabal Partnerschaftsgesellschaft mbB Patentanwälte
(86) International application number: PCT/JP2021/046270
(87) International publication number: WO 2022/138375

(57) **Abstract**

A surface-coated cutting tool includes a coating layer having a laminated structure that includes first sublayers and second sublayers having a cubic crystal structure and has an average thickness of 0.5 to 8 µm, the bottommost and topmost sublayers being both first sublayers;
the first sublayer has an average thickness of 0.1 to 2 µm and a composition (Al₁₋ₓCrₓ)N, where x = 0.20 to 0.60;
the second sublayer has an average thickness of 0.1 to 2 µm, has a composition (Al_{1-a-b}CrₐSi_{b})N where a=0.20 to 0.60, b=0.01 to 0.20, and has a repeated variation in Si content with an average interval of 1 to 100 nm between local minima and local maxima, the average local maximum and minimum are each within a specific range; and
the diffraction peaks of the 111 and 200 diffraction peaks each have a predetermined full width at half maximum and a peak intensity.

## Description

### Technical Field

The present invention relates to a surface coated cutting tool (hereinafter, also referred to as coated tool). This application claims priority benefit of Japanese Patent Application No. 2020-212386 filed on December 22, 2020. The entire contents of the Japanese application are hereby incorporated by reference herein.

### Background Art

In order to improve the tool lives of cutting tools, coated tools have been used that include coating layers formed on the surfaces of substrates made of, for example, tungsten carbide (hereinafter, referred to as WC) based cemented carbide. These coated tools can exhibit high wear resistance.

A variety of proposals have also been reported for further improvements in the cutting properties of coated tools.

For example, PTL 1 discloses a coated tool including a coating layer having a composition represented by (AlCrSi)(NOBC), wherein the coating layer has a 111 or 200 diffraction peak with a full width at half maximum ranging from 0.5 degrees to 2.0 degrees, and oxygen in the coating layer presents at the boundaries of crystal grains much more than the interiors of the crystal grains, resulting in an improvement in wear resistance of the coated tool.

For example, PTL 2 discloses a coated tool including a first sublayer having a composition represented by (AICrSi)N and a second sublayer having a composition represented by(TiSi)N with a columnar crystal structure, which are alternatingly deposited, as a coating layer, where the coated layer exhibits Is/Ir = 1 to 10 and It/Ir = 0.6 to 1.5 where Ir indicates the intensity of the 111 diffraction peak of the first sublayer, Is indicates the intensity of the 200 diffraction peak of the first sublayer and It indicates the intensity of 220 diffraction peak of the first sublayer; the lattice spacings d1, d2 of the 200 diffraction peaks of the first sublayer and the second sublayer satisfies 0.965 ≤ d1/d2 ≤ 0.990; and the second sublayer has a repeated variation in Si content, resulting in an improvement in wear resistance of the coated tool.

For example, PTL 3 discloses a coated tool that includes a coating layer that has an average thickness of 4 to 10 µm and consists of a first sublayer having a composition represented by (AlCr)N and a second sublayer having a composition represented by (TiSi)N. The first sublayer has a 111 diffraction peak with a full width at half maximum W1 of 0.7 to 1.1 degree and satisfies the expression: 0.3 ≤ Is/Ir ≤ 1.0 and 0.3 ≤ It/Ir < 1, where Ir indicates the intensity of the 111 diffraction peak, Is indicates the intensity of the 200 diffraction peak, and It indicates the intensity of the 220 diffraction peak, while the second sublayer has a 111 diffraction peak with a full width at half maximum W2 of 0.6 to 1.1 degree and satisfies the expression: 0.3 ≤ Iv/lu < 1.0 and 0.3 ≤ !w/!u < 1 where lu indicates the intensity of the 111 diffraction peak, Iv indicates the intensity of the 200 diffraction peak, and Iw indicates the intensity of the 220 diffraction peak, resulting in an improvement in wear resistance of the coated tool.

In addition, for example, PTL 4 discloses a coated tool including a coating layer that consists of first sublayers having a composition represented by (AlCr)N and second sublayers having a composition represented by (TiSi)N, which are alternatingly deposited, each having a thickness of 1 to 20 nm, where boundary regions comprising a mixture of the compositions of the first sublayer and second sublayer occupy 5 to 80% of the cross-sectional area of the entire coating layer. The resulting tool exhibits an improvement in wear resistance.

### Citation List

### Patent Literature

PTL 1: Japanese Unexamined Patent Application Publication No. 2005-126736
PTL 2: Japanese Unexamined Patent Application Publication No. 2011-93085
PTL 3: Japanese Unexamined Patent Application Publication No. 2012-45650
PTL 4: Japanese Patent No. 5087427

### Summary of Invention

### Technical Problem

An object of the present invention, which has been accomplished in view of the circumstances described above and the proposals described above, is to provide a coated tool including a surface coating layer exhibiting excellent wear resistance and fracture resistance.

### Solution to Problem

A surface coated cutting tool according to an embodiment of the present invention comprises:
1) a substrate and a coating layer on a surface of the substrate; wherein
2) the coating layer has an average thickness of 0.5 µm or more and 8.0 µm or less, and has a laminated structure comprising one or more first sublayers and one or more second sublayers alternately deposited;
3) both a topmost sublayer and a bottommost sublayer of the laminated structure of the cutting tool are two of the first sublayers;
4) each of the first sublayers has an average thickness of 0.1 µm or more and 2.0 µm or less and has an average composition represented by (Al₁₋ₓCrₓ)N (where 0.20 ≤ x ≤ 0.60);
5) each of the second sublayers has an average thickness of 0.1 µm or more and 2.0 µm or less, has an average composition represented by (Al_{1-a-b}CrₐSi_{b})N (where 0.20 ≤ a ≤ 0.60 and 0.01 ≤ b ≤ 0.20), and has a repeated variation in Si content such that the average interval between local maxima and adjacent local minima is 1 nm or more and 100 nm or less; and the Si content has an average Siₘₐₓ of the local maxima satisfying the expression: 1.0 < Siₘₐₓ/b ≤ 2.0 and an average Siₘᵢₙ of the local minima satisfying the expression 0.0 ≤ Siₘᵢₙ/b < 1.0;
6) both the first sublayers and the second sublayers comprise crystal grains of a NaCl-type face-centered cubic structure; and
7) the overall coating layer comprising the first sublayers and the second sublayers has a combined 111 X-ray diffraction peak with a full width at half maximum of 0.1 degrees or more and 1.0 degrees or less and a peak intensity I₁₁₁ and has a combined 200 X-ray diffraction peak with a peak intensity I₂₀₀, where the ratio I₁₁₁/I₂₀₀ is greater than 1.0 and less than 5.0.

The surface coated cutting tool according to the embodiment described above may further satisfy the following conditions (1) and/or (2), the following conditions (2) and (3), or all the following conditions (1) to (4):
(1) the topmost first sublayer of the laminated structure of the tool is replaced with a third sublayer that has an average composition represented by (Al_{1-y}Cr_{y})N (where 0.20 ≤ y ≤ 0.60) and has an average thickness of 0.3 µm or more and 4.0 µm or less, and the average thickness of the third sublayer is larger than that of the other first sublayers of the laminated structure.
(2) the topmost first sublayer or the third sublayer of the coating layer of the tool in the laminated layer is provided with a surface sublayer having an average thickness of 0.1 µm or more and 4.0 µm or less, having an average composition represented by (Ti_{1-α-β}Si_{α}W_{β})N (where 0.01 ≤ α ≤ 0.20 and 0.01 ≤ β ≤ 0.10), having a repeated variation in W content such that the average interval between local maxima and adjacent local minima is 1 nm or more and 100 nm or less, and the W content has an average Wₘₐₓ of the local maxima satisfying the expression: 1.0 < Wₘₐₓ/β ≤ 2.0 and an average Wₘᵢₙ of the local minima satisfying the expression: 0.0 ≤ Wₘᵢₙ/β ≤ 1.0.
(3) an intermediate sublayer is disposed between the topmost first sublayer or third sublayer of the coating layer of the tool in the laminated layer, the intermediate layer having an average thickness of 0.1 µm or more and 2.0 µm or less and an average composition represented by (Al₁₋ₖ₋ₗ₋ₘ₋ₙTiₖCrₗSiₘWₙ)N (where 0.20 ≤ k ≤ 0.65, 0.10 ≤ I ≤ 0.35, 0.00 < I ≤ 0.15, and 0.00 < n ≤ 0.05); and the intermediate sublayer has a repeated variation in Si content such that the average interval between local maxima and local minima is 1 nm or more and 100 nm or less, and the Si content has an average Simₘₐₓ of the local maxima satisfying the expression: 1.0 < Simₘₐₓ/m ≤ 2.0 and an average Simₘᵢₙ of the local minima satisfying the expression 0.0 ≤ Simₘᵢₙ/m < 1.0.

### Advantageous Effects of Invention

The surface coated cutting tool described above has excellent wear resistance and fracture resistance.

### Brief Description of Drawings

Figure 1 is a schematic diagram of a longitudinal section of a coating layer of a surface coated cutting tool according to one embodiment of the invention.
Figure 2 is a schematic diagram illustrating a repeated variation in Si content in the longitudinal section of the coating layer of the surface coated cutting tool according to one embodiment of the present invention.
Figure 3 is a schematic diagram of a longitudinal section of a coating layer of a surface coated cutting tool according to another embodiment of the present invention.
Figure 4 is a graph illustrating the results of XRD analysis of Example 4.
Figure 5 is a graph illustrating the results of XRD analysis of Example 14.
Figure 6 is a schematic plan view of an arc ion plating system used for formation of a coating layer in examples A and B.
Figure 7 is a schematic front view of the arc ion plating system shown in Figure 6.

The present inventors have studied a composite nitride layer composed of Al, Cr and Si (hereinafter, also referred to as (AlCrSi)N). As a result, the inventors have found that Al improves high-temperature hardness and heat resistance, Cr improves high-temperature strength, and a combination of Al and Cr results in an improvement in high-temperature oxidation resistance. Although Si improves heat resistance, it likely increases lattice strain in the (AICrSi)N at the same time, and thus the composite nitride layer has insufficient toughness, resulting in ready generation of chipping and fracture under application of a high load.

The present inventors have also found that simple deposition of the (AICrSi)N layer and another known coating layer (for example, a composite nitride layer composed of Ti and Si) barely avoids the occurrence of chipping and fracture because the toughness of the coating layer as a whole further decreases due to the strain caused by the misalignment of lattice constant at the interface to any other hard phase.

The inventor has further studied in view of these findings and has discovered the following new findings:
An (AlCrSi)N coating layer having a composition within a predetermined range and having a predetermined XRD pattern and a substrate are each covered by another highly adhesive coating layer, that is, an Al-Cr composite nitride (hereinafter referred to as (AICr)N) layer to form a laminated structure;
A composite nitride layer of Ti, Si and W (hereinafter sometimes referred to as (TiSiW)N) having a repeated variation in Si content is deposited on this laminated structure; and
An optional composite nitride layer of Al, Ti, Cr, Si and W (hereinafter sometimes referred to as (AITiCrSiW)N) having a repeated variation in W content is further deposited;
Such a configuration thereby enhances the adhesion of the coating layer to the substrate and the adhesion between individual layers, and increases the toughness of the entire coating layer. For example, under severe cutting conditions with continuous and interrupted cutting (hereinafter referred to as high-load cutting conditions), the resulting coated tool exhibits excellent wear resistance over a long period of time with reduced chipping and fracture.

The coated tool according to embodiments of the present invention will now be described in detail.

In the embodiments, only a first sublayer to a fifth sublayer are formed. In the case where a new upper layer is deposited on an already deposited layer (lower layer), pressure fluctuations unintentionally occurring in the deposition system sometimes causes an unintentional intermediate sublayer to be formed on the lower layer. The intermediate sublayer contains oxygen and carbon and thus has a different composition from the upper and lower layers.

Throughout the specification and claims, a numerical range represented by "L to M" (L and M are both numerical values) should include the upper limit (M) and the lower limit (L). In the case that only the upper limit (M) has a unit, the upper limit (M) and the lower limit (L) should have the same unit.

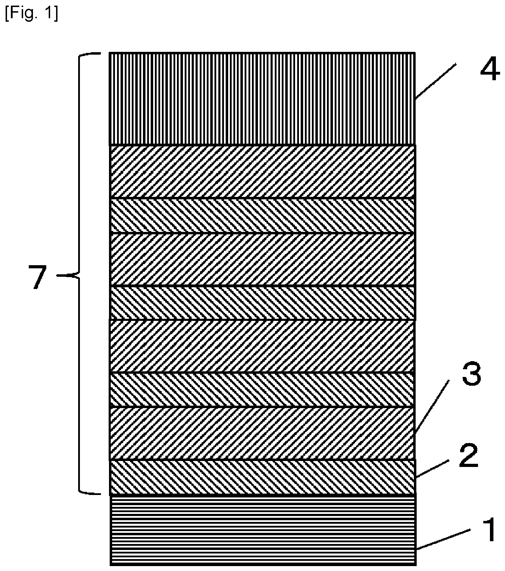

### I. Embodiment shown in FIG. 1

FIG. 1 schematically shows a longitudinal section of a surface-coated cutting tool according to one embodiment of the present invention. The embodiment shown in FIG. 1 will now be described. The longitudinal section refers to a section perpendicular to the surface of the substrate without considering minute irregularities on the surface of the substrate.

### 1. Coating layer

With reference to FIG. 1, the coating layer in this embodiment is deposited on a substrate (1), and has a laminated structure including first sublayers (2) and second sublayers (3) that are alternately deposited. As will be described below, the topmost sublayer of the coating layer of the coated tool may be a third sublayer (4). In ordinary cases, the topmost layer is the first sublayer (2) not the third sublayer (4). In the embodiment shown in FIG. 1, the third sublayer (4) is provided instead of the topmost first sublayer (2) of the tool.

### 1) First sublayer

In the composite nitride layer of Al and Cr, i.e., the (AlCr)N layer, which is the first sublayer constituting the laminated structure of the coating layer, Al improves high-temperature hardness and heat resistance, and Cr improves high-temperature strength. In addition, a combination of Cr and Al improves the high-temperature oxidation resistance.

In the average composition of the first sublayers of (AlCr)N, which is represented by the formula: (Al₁₋ₓCrₓ)N, the Cr content x is preferably 0.20 or more and 0.60 or less for the following reasons: A Cr content x less than 0.20 causes the high-temperature strength and the chipping resistance to decrease and the relative Al content to increase. Such a high Al content causes crystal grains with a hexagonal structure to appear. A Cr content exceeding 0.60 causes the relative Al content to decrease to an amount that does not ensure sufficient high-temperature hardness and heat resistance, resulting in low wear resistance. A more preferred range of the Cr content x is 0.25 or more and 0.50 or less.

According to an exemplary method described later, the first sublayers are produced such that the ratio AlCr: N is 1:1; however, the ratio may unintentionally deviate from 1:1 in some cases. This phenomenon also applies to other composite nitrides described below.

### (2) Second sublayer

In the second sublayer, which is an (AlCrSi)N layer, constituting the laminated structure of the coating layer together with the first sublayer, Cr improves the high-temperature strength and the chipping resistance of the coating layer; a combination of Cr and Al contributes to an improvement in high-temperature oxidation resistance, resulting in an improvement in wear resistance, like the first sublayer.

In addition, Si, which is a component of the second sublayer, can enhance the heat resistance and thermal plastic deformation resistance, but at the same time increases the lattice strain of the second sublayer, resulting in a decrease in chipping resistance of the second sublayer. To prevent such a disadvantage, the Si content is repeatedly varied as described later.

The average composition of the second (AICrSi)N sublayer is represented by the formula: (Al_{1-a-b}CrₐSi_{b})N, where the Cr content a is preferably 0.20 or more and 0.60 or less for the following reasons: A Cr content a of less than 0.20 causes the high-temperature strength to decrease, resulting in a reduction in chipping resistance, and the relative Al content to increase. Such a high Al content causes crystal grains with a hexagonal structure to appear, resulting in decreases in hardness and wear resistance. A Cr content a exceeding 0.60 causes the relative Al content to decrease, resulting in insufficient high-temperature hardness and heat resistance and low wear resistance. In more preferred embodiments the Cr content is within a range between 0.25 or more and 0.50 or less.

The Si content b is preferably 0.01 or more and 0.20 or less for the following reasons: A Si content b of less than 0.01 leads to an indistinctive increase in the heat resistance and thermal plastic deformation resistance of the second sublayer. A Si content b exceeding 0.20 tends to decrease the improvement in wear resistance, and, at the same time, leads to an increase in the lattice strain of the second sublayer, so that the lattice misalignment is noticeable between the first and second sublayers, resulting in a decrease in chipping resistance under high-load cutting conditions. In more preferred embodiments, the Si content b is within a range between 0.01 or and 0.15 or less.

In order to reduce the lattice strain more reliably, the average of the intervals between local maxima and adjacent local minima of the Si content in the direction perpendicular to the surface of the substrate (direction of the thickness, the definition will be described below), it is preferred that the Si content is repeatedly varied such that the average spacing ranges from 1 nm to 100 nm. Such a repeated variation suppresses a steep change in the Si content between the first sublayer and the second sublayer and more reliably reduces the lattice strain. As a result, the adhesion between these sublayers increases to an extent that can prevent detachment of the coating layer, and enhances the chipping resistance and fracture resistance.

Now will be described the reason why the average interval between the local maxima and adjacent local minima of the Si content is set to in the range between 1 nm or more and 100 nm or less. An average interval of less than 1 nm causes a steep change in the Si content to increases the local lattice strain. An average spacing exceeding 100 nm enlarges the region of a high Si content, that is, the region of large lattice strain. Large lattice strain results in readily chipping starting from that region, in other words, a decrease in chipping resistance. In more preferred embodiments, the average interval of a repeated variation is within a range between 5 nm or more and 50 nm or less

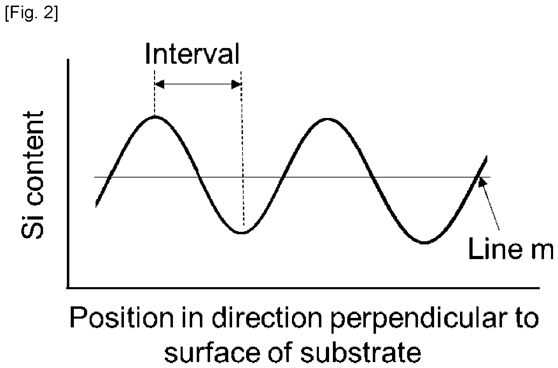

FIG. 2 is a schematic diagram showing part of a typical example of a repeated variation in Si content. FIG. 2 depicts such that the local maxima and local minima has the same value and the intervals between local maxima and adjacent local minima are also the same. The repeated variation in Si content throughout the specification and claims refer to alternating variations between local maxima and local minima of the Si content. The local maxima and the local minima may be the same or different values and the intervals between local maxima and adjacent local minima may also be the same or different values.

The average Siₘₐₓ of the local maxima of the Si content preferably satisfies the expression: 1.0 < Siₘₐₓ/b ≤ 2.0, while the average Siₘᵢₙ of the local minima of the Si content satisfies the expression: 0.0 ≤ Siₘᵢₙ/b < 1.0, where b is the average Si content b in the formula indicating the composition of the second sublayer.

Now will be described the reason why the ratio Siₘₐₓ/b of the average local maximum to the Si content b and the ratio Siₘᵢₙ/b of the average local minimum to the Si content b are determined as described above. A ratio Siₘₐₓ/b of more than 1.0 and a ratio Siₘᵢₙ/b of less than 1.0 lead to a reduction in the lattice strain due to a repeated variation in the Si content. A ratio Siₘₐₓ/b of more than 2.0 however leads to a large variation, in other words, a steep variation in the Si content, resulting in a decrease in chipping resistance.

More preferred embodiments, the ratios Siₘₐₓ/b and Siₘᵢₙ/b satisfy the expressions 1.2 < Siₘₐₓ/b ≤ 2.0 and 0.0 ≤ Siₘᵢₙ/b < 0.8, respectively.

The average interval between the local maxima and the adjacent local minima of the Si content is determined by measuring the Si content across the thickness of the second sublayer, subjecting the observed value to known noise reduction, and plotting the data.

In detail, as shown in FIG. 2, a straight line m is drawn across the curve indicating a repeated variation in the Si content (in FIG. 2, the straight line crosses two local maxima and local minima. However, the straight line m may have any length suitable for accurate determination of the average local maximum and average local minimum and the average interval). This straight line m is drawn so that the area of the area surrounded by the curve is equal to the upper half and lower half of the straight line m. The local maxima and local minima of the Si content are determined for each region that is defined by the curve indicating the repeated variation of Si content and the straight line m, and the intervals between the local maxima and adjacent local minima are determined. The data determined from multiple positions are then averaged. As a result, the average interval of a repeated variation in Si content in the second sublayer is calculated.

The average local maximum Siₘₐₓ and the average local minimum Siₘᵢₙ of the Si content are calculated by averaging the local maxima and local minima of the Si content determined at multiple positions.

### (3) Laminated structure

The laminated structure of the coating layer includes first and second sublayers alternately laminated.

The first and second sublayers each have an average thickness of preferably 0.1 µm or more 2.0 µm or less. An average thickness within this range alleviates the lattice misalignment between the first and second sublayers, resulting in improvements in chipping resistance and wear resistance of the coating layer. As described below, the topmost first sublayer of the laminated structure of the coating layer may be replaced with a third sublayer. The alternative third sublayer may contribute to a more reliable achievement in the above-mentioned purpose.

The laminated structure of the first sublayer and second sublayer alternately deposited preferably has an average thickness of 0.5 µm or more and 8.0 µm or less. An average thickness of the laminated structure of less than 0.5 µm fails to an achievement of sufficiently high wear resistance over a long period of time, while an average thickness exceeding 8.0 µm readily causes abnormal damage, such as chipping, fracture, and separation. In more preferred embodiments, this average thickness is within a range between 1.0 µm or more and 7.0 µm or less.

The preferred range of the average thickness of a laminated structure (the average thickness of the overall coating layer) including a third sublayer to a fifth sublayer described later is the same as that of the laminated structure including only the first and second sublayers.

Each of the bottommost and topmost sublayers of the laminated structure of the coating layer of the coated tool are preferably the first sublayers for the following reasons: The bottommost first sublayer adjacent to the substrate ensures high adhesion strength between the substrate and the coating layer, while the topmost first sublayer of the coating tool ensures high chipping resistance during cutting processes under high-load cutting.

Any number of first and second sublayers may be deposited under the restrictions: the bottommost and topmost sublayers being first sublayers; the average thickness of the first and second sublayers being within a range between 0.1 µm or more and 2.0 µm of less, and the total thickness of the laminated structure being within a range between 0.5 µm or more and 8.0 µm or less. In more preferred embodiment, the laminated structure consists of three to six first sublayers and second sublayers, for example, five first sublayers and four second sublayers.

The topmost first sublayer of the laminated structure may be replaced with a third sublayer. The third sublayer has an average composition represented by (Al_{1-y}Cr_{y})N. In a more preferred embodiments, the atomic ratio y is 0.20 or more and 0.60 or less (where y and x may be the same or different), the third sublayer has an average thickness in the range between 0.3 µm or more and 4.0 µm or less, and the average thickness of the third sublayer is larger than the average thickness of the first sublayers of the laminated structure, for the reasons that follows:

The topmost third or (AlCr)N sublayer, which has relatively low lattice strain compared to the second sublayer and is thicker than the first sublayer, will more efficiently buffer the impact during high-load cutting processes. An average thickness less than 0.3 µm of the topmost (AlCr)N sublayer of the coating tool causes an insufficient improvement in chipping resistance, while an average thickness exceeding 4.0 µm causes a large proportion of (AICr)N sublayer in the hard coating layer, resulting in low wear resistance. In more preferred embodiments, the atomic ratio y of the third sublayer is within a range between 0.25 or more and 0.50 or less. The average thickness is more preferably within a range between 0.5 µm or more and 2.0 µm or less.

### (4) Crystal grains of NaCl-type face-centered cubic structure

The crystal grains that make up the first, second, and third sublayers preferably have a NaCl-type face-centered cubic structure. It should be noted that these sublayers may include incidental or unintentional amounts of crystal grains having crystal structures other than the NaCl-type face-centered cubic structure.

### (5) XRD pattern

It is preferred that the full width at half maximum of the overall X-ray 111 diffraction peak assigned to the first, second, and third sublayers is within the range between 0.1 degree or more and 1.0 degree or less and the ratio I₁₁₁/I₂₀₀ is above 1.0 and less than 5.0 where I₁₁₁ is the diffraction peak intensity of the 111 diffraction peak and I₂₀₀ is the diffraction peak intensity of the 200 diffraction peak. In more preferred embodiments, the full width at half maximum of the overall 111 diffraction peak is within a range between 0.1 degrees or more and 0.5 degrees or less and the ratio I₁₁₁/I₂₀₀ is above 1.1 and less than 4.0.

In a combination of a full width at half maximum within the above range and a ratio I₁₁₁/I₂₀₀ within the above range, the laminated structure has excellent chipping resistance and wear resistance. Although the reason is not completely clear, the full width at half maximum within such a range would improve the crystallinity of the laminated structure, which contributes to an improvement in wear resistance and would reduce the difference in the crystal lattice constant between the first, second, and third sublayers, which contributes to an improvement in chipping resistance. As a result, strain due to lattice misalignment decreases at interfaces between the first, second, and third sublayers, resulting in improvements in abrasion resistance and chipping resistance. The ratio of peak intensities demonstrates that the (111) plane being the densest plane of the NaCl-type face-centered cubic structure is predominant, would contribute to a further improvement in wear resistance.

The "overall X-ray 111 diffraction peak" assigned to the first and second sublayers indicates that X-ray diffraction peaks assigned to the first and second sublayers are obtained not individually but in an overlapping state. Similarly, the "overall X-ray 111 diffraction peak" assigned to the first, second, and third sublayers indicates that X-ray diffraction peaks assigned to the first, second, and third sublayers are obtained not individually but in an overlapping state.

### 2. Substrate

### (1) Materials

The substrate may be formed of any known material that fills the purpose of the present invention. Examples of such material include cemented carbide alloys (e.g., WC-based cemented carbide alloy containing WC, elemental Co, and carbonitrides of, for example Ti, Ta, and Nb), cermets (primarily containing TiC, TiN, and TiCN), ceramics (e.g., titanium carbide, silicon nitride, aluminum nitride, and aluminum oxide), cBN sinters, and diamond sinters.

### (2) Shape

The substrate may have any shape suitable for a cutting tool. Examples of such a shape include the shapes of inserts and drills.

### 3. Production

An exemplary method of producing a tool according to the present embodiment is layer deposition by the following PVD process.

Arc discharge is generated between an Al-Cr alloy target and an anode to form a first sublayer with a predetermined average thickness. While the arc discharge is continued, other arc discharge is generated between an Al-Cr-Si alloy target and another anode under predetermined deposition conditions, such as rotating cycle of a turn table, nitrogen pressure, bias voltage, and temperature of the PVD system to form a second sublayer having a repeated variation in Si content.

After the deposition of the second sublayers with a predetermined thickness, the arc discharge between the Al-Cr-Si alloy and the anode is interrupted, whereas only the arc discharge between the Al-Cr alloy target and the anode is continued to form another first sublayer of a prescribed average thickness.

These operations are repeated to form a laminated structure including a specified number of first sublayers and second sublayers. Optionally, a third sublayer may be provided. In the case of forming (AlCr)N layers with different average compositions between the first and third sublayers, another Al-Cr alloy target, in addition to the Al-Cr alloy target for the first sublayer, is provided for the third sublayer.

Controlling the alloy compositions of the targets for the first, second, and the third sublayers to predetermined values and deposition conditions can yield X-ray diffraction patterns according to the present embodiment.

Alternatively, the second sublayer can be formed by single arc discharge between the Al-Cr-Si alloy target and the anode under modified deposition conditions, without generation of arc discharge between the Al-Cr alloy target and the anode.

Regarding a repeated variation in Si content and control of X -ray diffraction patterns, the deposition with an Al-Cr alloy target is superior to that with only the Al-Cr-Si alloy target.

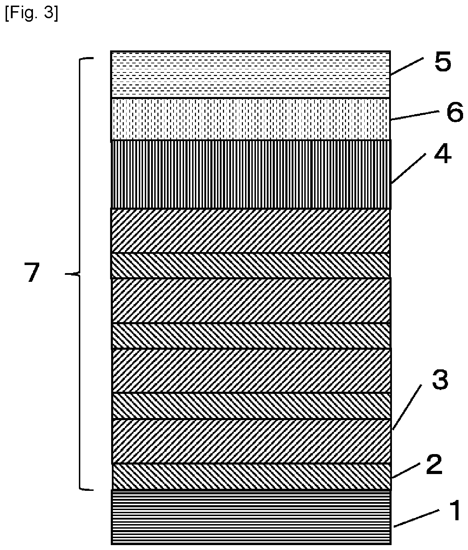

### II. Embodiment shown in Fig. 3

FIG. 3 schematically illustrates a longitudinal section of the surface-coated tool according to another embodiment of the present invention. The embodiment shown in FIG. 3 will now be described. It is noted that redundant description is omitted on the parts that duplicate the description of the embodiment shown in FIG. 1.

### 1. Coating layer

### (1) Laminated structure and its sublayers

The coating layer of the present embodiment has a laminated structure including first sublayer (2), second sublayers (3), and an optional third sublayer (4), like the embodiment in FIG. 1. The laminated structure further includes an intermediate sublayer (fifth sublayer) (6) and a surface sublayer (fourth sublayer) (5) in sequence on the third sublayer (4). FIG. 3 illustrates an embodiment with the optional sublayers: the third, fourth, and fifth sublayers.

The term "optional A layer" means that the A layer may be present or not. For example, the third sublayer (4) may be replaced with a first sublayer (2).

### (2) Surface sublayer

In the present embodiment, the surface sublayer (fourth sublayer) has a predetermined composition and a structure of a complex nitride compound composed of Ti, Si, and W (hereinafter referred to as (TiSiW)N) and is disposed on the topmost first or third sublayer of the laminated structure.

The surface sublayer, which is primarily composed of Ti and contains Si, further improves the oxidation resistance and heat resistant deformation of the coating layer. The surface sublayer, which further contain W, improves the high temperature strength and wear resistance of the coating layer.

The surface sublayer preferably has an average thickness in the range between 0.1 µm or more and 4.0 µm or less for the following reasons: An average thickness within such a range further improves the chipping resistance, fracture resistance, and abrasion resistance of the coating layer under high-load cutting conditions. In more preferred embodiments, the average thickness is within a range between 0.1 µm or more and 2.0 µm or less.

The surface sublayer (fourth sublayer) preferably has an average composition represented by the formula: (Ti_{1--a-β}Si_{α}W_{β})N where 0.01 ≤ α ≤ 0.20 and 0.01 ≤ β ≤ 0.10.

In the case of α less than 0.01, the surface sublayer has insufficient improvement in oxidation resistance and heat-resistant deformation. In the case of α exceeding 0.20, the lattice strain increases to cause the surface sublayer to chip under high-load cutting conditions.

In the case of β less than 0.01, the surface sublayer does not exhibit a sufficient improvement in strength at high temperatures, which is an advantage for the surface sublayer. In the case of β exceeding 0.10, the lattice strain increases to cause the chipping resistance of the surface sublayer to decrease under high-load cutting operations.

It is preferred that the W content has a repeated variation in the range of 1 nm to 100 nm in the average interval between the local maxima and adjacent local minima, the average value Wₘₐₓ of the local maxima of the W content satisfies the expression 1.0 < Wₘₐₓ/β ≤ 2.0, and the average value Wₘᵢₙ of the local minima of the W content satisfies the expression 0.0 ≤ Wₘᵢₙ/β < 1.0, where β is the average composition of the W in the formula on the composition of the surface sublayer (fourth sublayer).

The reason why the average interval between the adjacent local maximum and local minimum is preferably 1 nm or more 100 nm or less is as follows: An average interval of less than 1 nm causes a steep change in the W content, so that the lattice strain on the surface sublayer locally increases and thus the chipping resistance of the coating layer decreases. An average interval exceeding 100 nm causes expansion of the area with large lattice strain on the surface sublayer, so that cracking readily occurs in the area to decrease the chipping resistance. In more preferred embodiments, the average interval of a repeated variation is within a range between 5 nm or more and 50 nm or less.

The ratio Wₘₐₓ/β of the average local maximum to β and the ratio Wₘᵢₙ/β of the average local minimum to β are determined as above for the following reasons: A combination of a ratio Wₘₐₓ/β exceeding 1.0 and a ratio Wₘᵢₙ/β of less than 1.0 causes a decrease in lattice strain in the surface sublayer. A ratio Wₘₐₓ/β exceeding 2.0 causes a large variation in composition, that is, a steep variation in W content, resulting in a decrease in chipping resistance of the surface sublayer. In more preferred embodiments, the following expressions on Wₘₐₓ/β and Wₘᵢₙ/β hold: 1.2 < Wₘₐₓ/β ≤ 2.0 and 0.0 ≤ Wₘᵢₙ/β < 0.8.

The average interval, Wₘₐₓ, and Wₘᵢₙ relating to the repeated variation in the W content can be determined as in the repeated variation in the Si content described with reference to FIG. 2. In other words, FIG.2 can be read in which Si is replaced with W

### (3) Intermediate sublayer

In the present embodiment, an intermediate sublayer (fifth sublayer) having a predetermined composition and structure of a complex nitride compound of Al, Cr, Ti, Si, and W (hereinafter referred to as (AlCrTiSiW)N)) may be further disposed between the surface sublayer (fourth sublayer) and the first or third sublayer of the laminated structure. In the present embodiment, the intermediate sublayer is optional, not essential. In other words, the intermediate sublayer may or not be provided. This intermediate sublayer further improves the chipping resistance, fracture resistance, and abrasion resistance of the coating layer.

It is preferred that the intermediate sublayer has an average thickness in the range of 0.1 µm to 2.0 µm for the following reasons: An average thickness of less than 0.1 µm leads to insufficient adhesion of the surface sublayer to the first or third sublayer, whereas an average thickness exceeding 2.0 µm leads to large lattice strain in the intermediate sublayer and thus an unexceptional decrease in adhesion to the adjacent layers. In more preferred embodiments, the average thickness ranges from 0.1 µm to 1.0 µm.

The average composition of the intermediate sublayer is preferably represented by the Formula: (Al₁₋ₖ₋ₗ₋ₘ₋ₙTiₖCrₗSiₘWₙ)N where 0.20 ≤ k ≤ 0.65, 0.10 ≤ l ≤ 0.35, 0.00 < m ≤ 0.15, and 0.00 < n ≤ 0.05.

The reason why the ranges of the composition range are determined will now be described.

Among components that makes up the intermediate sublayer, Al improves the high-temperature hardness and heat resistance of the intermediate sublayer, Ti improves the high-temperature hardness and high-temperature strength, Cr improves the high-temperature strength and lubricity of the intermediate sublayer, and the Si Improves the oxidation resistance and plastic deformation resistance of the intermediate sublayer. W, which is the other component, further improves the high temperature strength and thus the wear resistance of the intermediate sublayer.

A Ti content less than 0.20 fails to achieve sufficient high-temperature hardness and high-temperature strength of the intermediate sublayer and to lead to a relatively high Al content. Such a high Al content facilitates formation of hexagonal crystals in the intermediate sublayer, resulting in low adhesion between the surface sublayer and the first or third sublayers. A Ti content exceeding 0.65 leads to decreases in relative contents of the other ingredients, resulting in insufficient wear resistance of the intermediate sublayer. In more preferred embodiments, the Ti content ranges from 0.20 to 0.50.

A Cr content less than 0.10 fails to achieve sufficient high-temperature strength and lubricity of the intermediate sublayer, whereas a Cr content exceeding 0.35 leads to decreases in relative contents of the other components, resulting in insufficient wear resistance. In more preferred embodiment, the Cr content ranges from 0.10 to 0.25 or less.

A Si-free system (a Si content of 0.00) fails to achieve high oxidation resistance and plastic deformation of the intermediate sublayer, resulting in poor affinity and thus low adhesion to the first or third sublayer. A Si content exceeding 0.15 leads to large lattice strain in the intermediate sublayer, resulting in low adhesion between the surface sublayer and the first or third sublayer. In more preferred embodiment, the Si content ranges 0.03 to 0.15.

A W-free system (a W content of 0.00) fails to achieve insufficient high-temperature strength of the intermediate sublayer, while a W content exceeding 0.05 leads to large lattice strain in the intermediate sublayer, resulting in low adhesion to the surface sublayer. In more preferred embodiment, the W content ranges from 0.01 to 0.05.

It is preferred that the Si content has a repeated variation in the range of 1 nm to 100 nm in the average interval between the local maxima and adjacent local minima. The average value Simₘₐₓ of the local maxima of the Si content satisfies the expression 1.0 < Simₘₐₓ/m ≤ 2.0, and the average value Simₘᵢₙ of the local minima of the Si content satisfies the expression: 0.0 ≤ Simₘᵢₙ/m < 1.0.

The reasons why 1 nm or more and 100 nm or less is preferable as an average interval between the local maxima and adjacent local minima are as follows: An average interval less than 1 nm leads to a steep variation in the Si content, facilitating chipping of the coating layer and precluding an improvement in adhesion between the surface sublayer and the first or third sublayer. An average interval exceeding 100 nm leads to an expansion of the area of a high Si content, in other words, the area of high lattice strain, resulting in ready occurrence chipping from the area and thus insufficient adhesion. In more preferred embodiments, the average interval of a repeated variation ranges from 5 nm to 50 nm.

The reasons for determination of the ratio Simₘₐₓ/m of the average local maximum to the Si content m and the ratio Simₘᵢₙ/m of the average local minimum to the Si content m are as follows: A combination of a ratio Simₘₐₓ/m exceeding 1.0 and a ratio Simₘᵢₙ/m less than 1.0 causes a repeated variation in Si content. A ratio Simₘₐₓ/m exceeds 2.0 causes a large or steep variation in Si content, resulting in a decrease in the chipping resistance of the coating layer.

It is preferred that the fourth and fifth sublayers are composed of crystal grains of a NaCl-type face-centered cubic crystal structure. These layers may also contain incidental crystal grains with a crystal structure other than the NaCl-type cubic structure in an inevitable (unintended) amount, like the first, second, and third sublayers.

The embodiment shown in FIG. 3 depicts a case that the coating layer includes a third sublayer and an intermediate sublayer (fifth sublayer). In the present embodiment, however, the third and/or intermediate sublayer (fifth sublayer) is not essential, and can be omitted.

### 2. Substrate

The material for and shape of the substrate are the same as those described in the embodiment shown in FIG. 1.

### 3. Production

The first, second and third sublayers are produced according to the embodiment shown in FIG. 1.

### (1) Surface sublayer (fourth sublayer)

The surface sublayer can be formed by, for example, the following PVD process.

Arc discharge are generated between two Ti-Si-W alloy targets having different compositions and their respective anodes at the same time while deposition conditions are adjusted, to form a repeated variation in the W content.

Alternatively, a single arc discharge is generated with a single Ti-Si-W alloy target while the deposition conditions are adjusted, to form a repeated variation in the W content, as in deposition in the second sublayer.

### (2) Intermediate sublayer (fifth sublayer)

The intermediate sublayer can be formed by, for example, the following PVD process.

Arc discharge are generated between an Al-Cr-Si alloy target and an anode and between a Ti-Si-W alloy target and their respective anode at the same time under predetermined deposition conditions.

Besides the combination of the Al-Cr-Si and Ti-Si-W alloy targets, other combinations, such as a binary combination of an Al-Cr alloy target and a Ti-Si-W alloy target, and a ternary combination of an Al-Cr-Si alloy target, an Al-Cr alloy target, and a Ti-Si-W alloy target are also available.

### III. Measurement

### 1. Measurement of average composition, and average thicknesses of individual sublayers and interfacial layers between sublayers

The content of each component in each sublayer can be measured several times by scanning electron microscopy (SEM), transmission electron microscopy (TEM), and energy dispersive X-ray spectroscopy (EDS) with a longitudinal cross-sectional sample, and the results are averaged.

The surface of the substrate is defined by a reference line of the roughness curve of an interface between the substrate and the coating layer in the observed image of the cross section. In the case of a substrate having a flat surface, such as an insert, elements are mapped on a longitudinal cross-section by EDS, and the mapped data is subjected to known image analysis to define an interfacial roughness curve between the bottommost first sublayer and the substrate. An average or reference straight line is arithmetically determined from the roughness curve and is defined as the surface of the substrate. The thickwise direction is defined as a direction perpendicular to the average straight line. Also in the case of the substrate of a drill having a curved surface and a diameter sufficiently larger than the thickness of the coating layer, the interface between the coating layer and the substrate is substantially flat within an observed region; hence, the surface of the substrate can be determined as above. In detail, elements are mapped in a longitudinal direction of a coating layer axially perpendicular to the drill by EDS and the mapped data is subjected to known image analysis to define a roughness curve of an interface between the coating layer and the substrate. An average line is arithmetically determined from the roughness curve and is defined as the surface of the substrate. A direction perpendicular to the average line or the surface of the substrate is then defined as a thickwise direction of the coating layer.

It should be noted that the observation area in the longitudinal section is determined so as to include the entire thickness of the coating layer. In view of the thickness of the coating layer and the accuracy of the measurement on the thickness, it is preferred to observe several fields of view (for example, three fields of view) of about 10 µm by10 µm.

Since the second sublayer, the surface sublayer (fourth sublayer), and the intermediate sublayer (fifth sublayer) have repeated variations in Si and W contents respectively, the Si and W contents in each layer are measured on several analytical lines (for example, five lines) along the direction perpendicular to the surface of the substrate (thickwise direction of the coating layer) to determine the Si and W contents, and each position at which the content is 1 atomic % (i.e., position at b = 0.01 or β = 0.01) is defined as an interface to the adjacent layer. Thicknesses are then determined from these analytical lines and are averaged to yield an average thickness. For the solitary third sublayer, the thicknesses are measured on several analytical lines and averaged to give an average thickness.

The average content of individual elements that make up each layer is the average of the results of the line analysis for individual layers.

### 2. Confirmation of crystal grains with NaCl-type face-centered cubic structure

By electron diffractometry with a transmission electron microscope (TEM), the crystal structures of each of the first sublayer, second sublayer, third sublayer, surface sublayer (fourth sublayer), and intermediate sublayer (fifth sublayer) are identified, to confirm that the crystal grains have a NaCl-type face-centered cubic structure.

### EXAMPLES

The present invention will now be described with reference to examples, which should not be construed to limit the present invention.

### <Example A>

An example corresponding to the embodiment of a coated tool with a coating layer shown in FIG. 1 will now be described, in which the coating layer includes a laminated structure including a first sublayer and a second sublayer, but not including a third sublayer, and thus the topmost layer of the laminated structure is a first sublayer.

Drill substrates were prepared.

Raw material powders, i.e., Co powder, VC powder, TaC powder, NbC powder, Cr₃C₂ powder, and WC powder, all having an average particle size of 0.5 to 5 µm, were prepared and compounded as shown in Table 1. Wax was added to the mixture and the blends were wet-mixed in a ball mill for 72 hours, were dried under reduced pressure, and then were compacted under a pressure of 100 MPa. The green compacts were sintered into round bar sinters with a diameter of 6 mm for substrates. These round bar sinters were subjected to a grinding process to form drill substrates 1 to 3 made of WC-based cemented carbide, each having a double blade shape with a groove having a diameter of 6 mm and a length of 48 mm and a helix angle of 30 degrees.

**[Table 1]**

| Drill substrate | Composition (Mass%) | | | | | |
|---|---|---|---|---|---|---|
| | Co | VC | TaC | NbC | Cr₃C₂ | WC and incidental impurities |
| 1 | 10.0 | 0.0 | 0.0 | 0.0 | 0.8 | Balance |
| 2 | 8.0 | 0.0 | 0.9 | 0.1 | 0.0 | Balance |
| 3 | 6.0 | 0.2 | 0.0 | 0.0 | 0.3 | Balance |

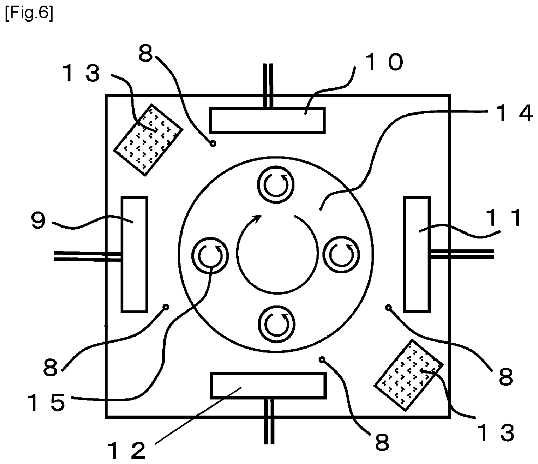

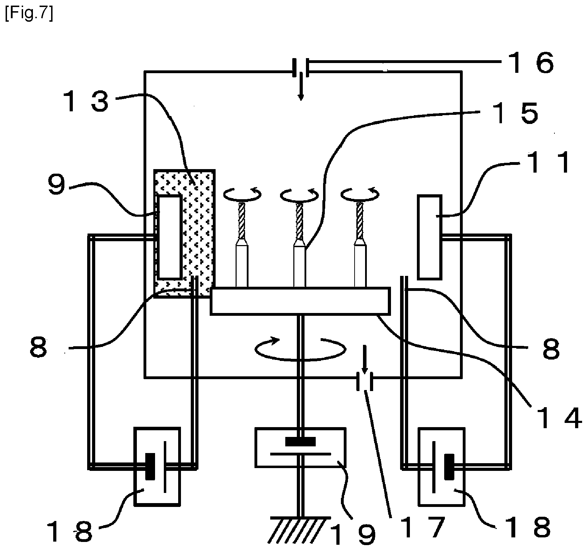

Layer deposition was performed as follows:
Drill substrates 1 to 3 were subjected to the following treatments (1) to (5) in sequence in an arc ion plating system shown in FIGS. 6 and 7.
(1) Drill substrates 1 to 3 were ultrasonically cleaned in acetone, were dried, and were placed in a dried state along the outer circumference at a predetermined distance radially away from the central axis on a turn table in the arc ion plating system.
(2) While the inside of the system was evacuated and maintained at a vacuum of 10⁻² Pa or less, the inside of the system was heated to 500°C with a heater and purged with Ar with a pressure of 0.2 Pa, and a DC bias voltage of -200 V was applied to the drill substrates spinning on the turn table to bombard the surfaces of the drill substrates with argon ions for 20 minutes.
(3) The system was purged with nitrogen reactive gas and maintained under a pressure of gaseous nitrogen shown in Table 2 at a predetermined temperature. A predetermined DC bias voltage was applied to the spinning drill substrate on the turn table that was controlled to the rotation speed while a predetermined current was applied between an Al-Cr alloy target and an anode to generate an arc discharge. A first sublayer having a predetermined average thickness was thereby deposited.
(4) As shown in Table 2, under a predetermined DC bias voltage, a predetermined current was applied between an Al-Cr alloy target and the anode to generate an arc discharge while a predetermined current was applied between an Al-Cr-Si alloy target and another anode to generate another arc discharge at the same time to deposit a second sublayer with a predetermined average thickness on the first sublayer where the deposited second sublayer had a repeated variation in Si content.
(5) Treatments (3) and (4) were repeated to deposit a predetermined number of first sublayers and a predetermined number of second sublayers. In several examples, a third sublayer was formed on the topmost second sublayers to yield a hard coating layers of, Examples 1-6 shown in Table 4, with proviso that the third sublayer was not formed in Examples 3 and 5.

In the case that the composition of the third sublayer was different from the composition of the first sublayer, the target indicated by reference numeral 9 in FIGS.6 and 7 was replaced with an Al-Cr alloy for deposition of the third sublayer.

In the deposition conditions for the first, second, and third sublayers in treatments (1) to (5), the arc current, nitrogen gas partial pressure as the reaction gas, the bias voltage, and the reaction temperature were controlled during simultaneous deposition using the Al-Cr alloy target and the Al-Cr-Si alloy target, such that the full width at half maximum of the 111 diffraction peak and the ratio I₁₁₁/I₂₀₀ of the intensity of the 111 diffraction peak to that of the 200 diffraction peak of the crystal grains of the NaCl-type face-centered cubic structure of the laminated structure had predetermined values as shown in Table 4.

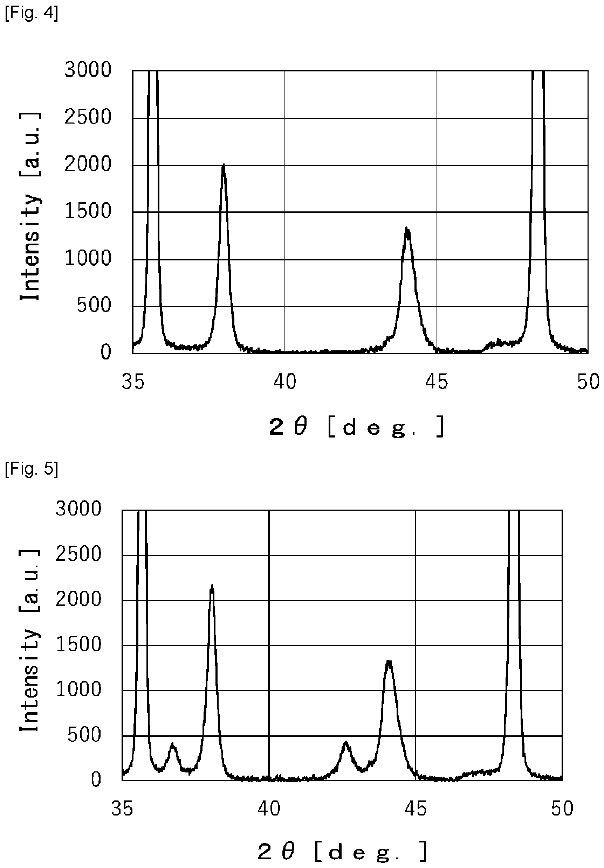

The X-ray diffractometric results of Example 4 are shown in FIG 4. X-ray diffractometry was carried out with Cu-Kα rays under the conditions of an angle range (2θ) of 30 to 80 degrees, a scanning step of 0.015 degrees, an observing time per step of 0.23 sec/step by a 2θ/θ parafocusing method. FIG. 4 shows a combined 111 diffraction peak at approximately 38 degrees and a combined 200 diffraction peak at approximately 44 degrees that are assigned to the first, second, and third sublayers. In the drawing, the peaks at approximately 36 degrees and 48 degrees are assigned to hexagonal WC. Since the conditions for the X-ray diffractometry in Example 4 are for illustrative purposes, other conditions may also be employed that can identify the 111 and 200 diffraction peaks.

For comparison, laminated structures containing first sublayers and second sublayers were formed on drill substrates 1 to 3 under the conditions shown in Table 3 as in Examples 1 to 6. Third sublayers were deposited in several Comparative Examples. Comparative example coated tools (referred to as "comparative examples") 1 to 6 shown in Table 5 were thereby produced. In Comparative Examples 3 and 6, the third sublayer was not formed.

The average thickness, average composition, and a repeated variation in Si content (Siₘₐₓ, Siₘᵢₙ, average interval between local maxima and adjacent local minima) of each layer of Examples and Comparative Examples were determined by the procedure described above. It was also confirmed by the procedure described above that the first to third sublayers contained crystal grains with a NaCl-type face-centered cubic structure.

In all examples and comparative examples, no diffraction peak indicating a crystal structure other than the NaCl-type face-centered cubic structure was observed. The results demonstrate that observable amounts of crystal grains were not present that have crystal structures other than the NaCl-type face-centered cubic structure.

The second sublayer in Comparative Example tool 2 was formed by a single Al-Cr-Si alloy target where the temperature of the system and the absolute value of the bias voltage were higher and the N₂ gas pressure was lower than those in Examples. Such an environment precluded the formation of a repeated variation in Si content and thus the formation of a repeated structure of the Si composition in the second sublayer. In other words, the Si content along the thickness of the second sublayer was almost uniform, and no repeated variation in Si content was observed (see Table 5). The structure in the second sublayer was different from that of Example tools.

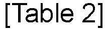

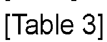

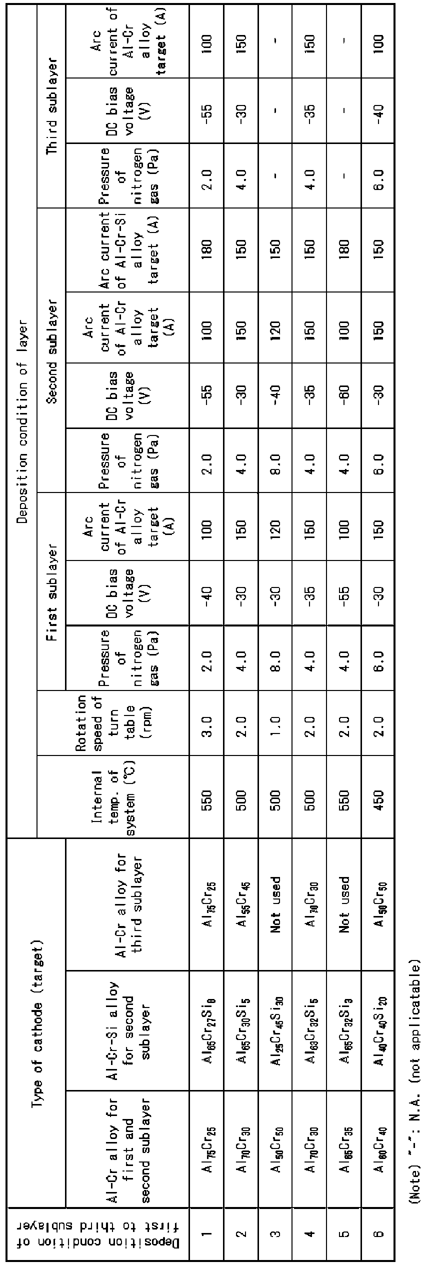

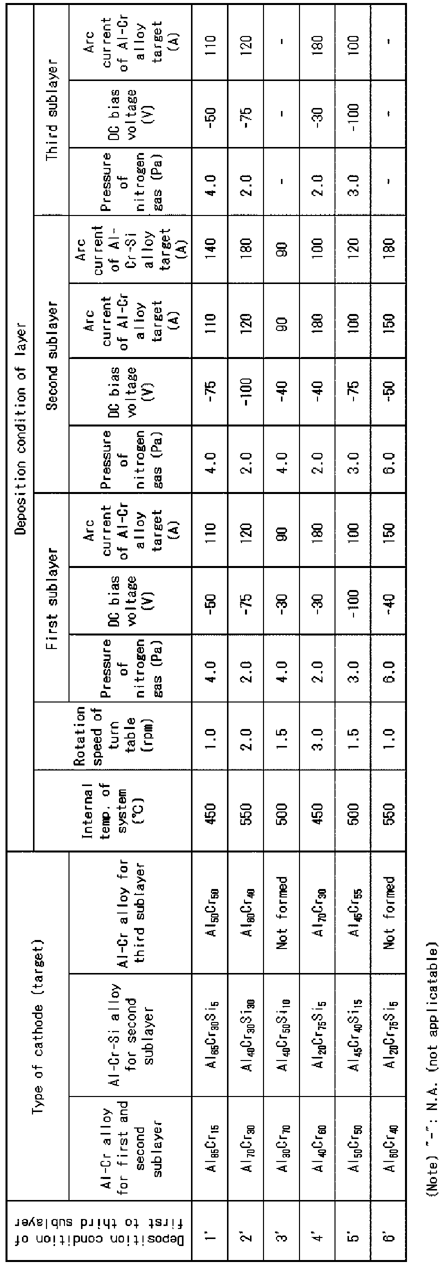

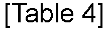

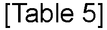

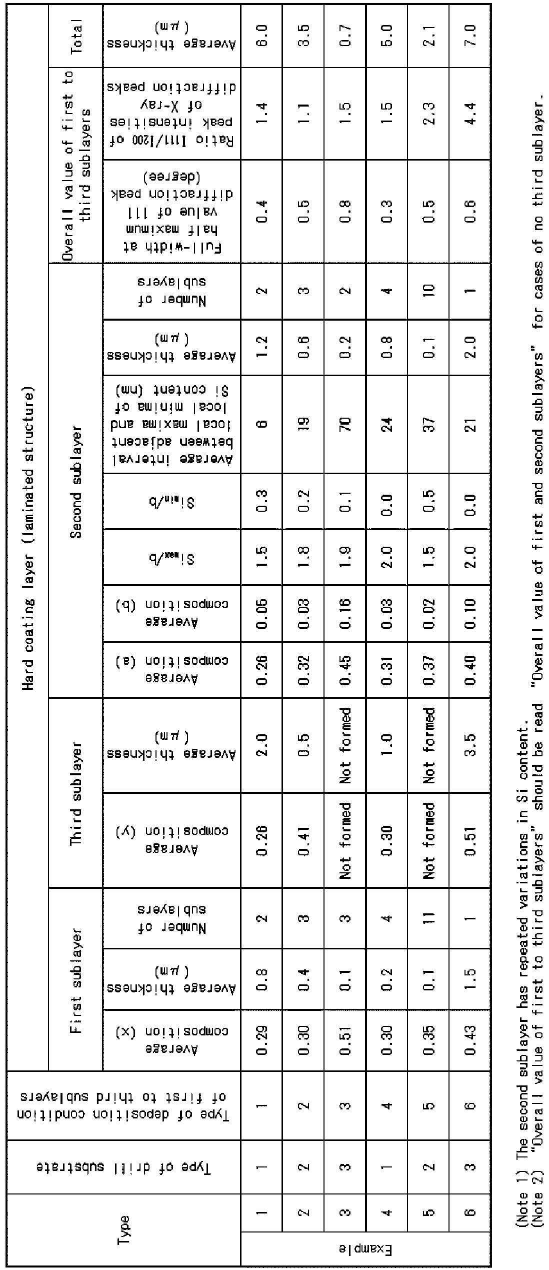

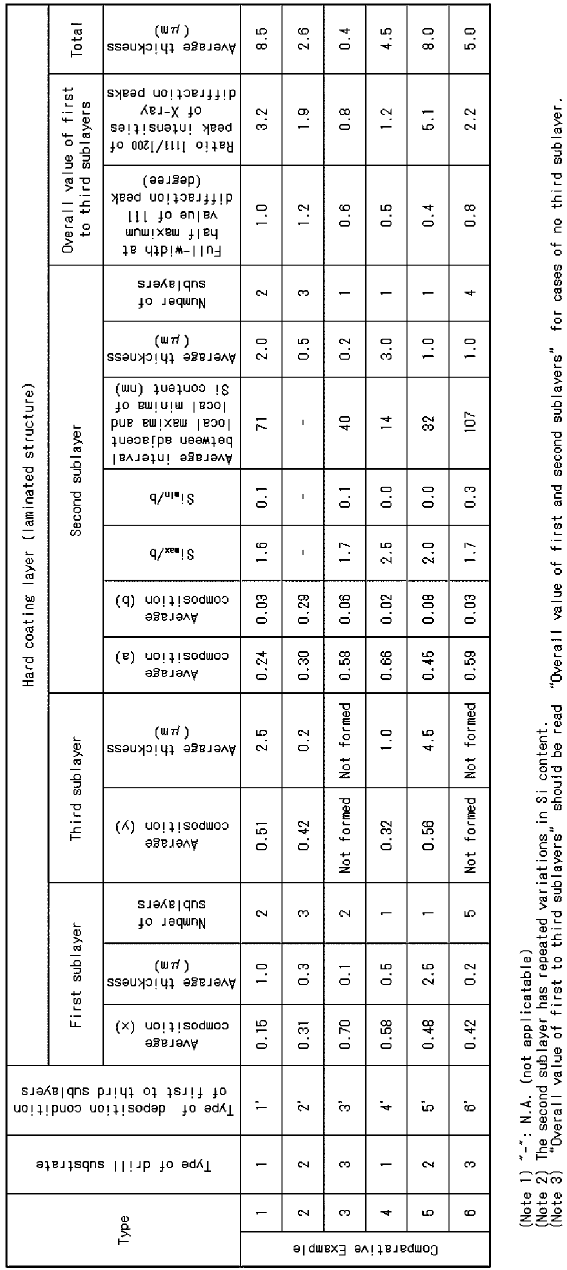

The samples of Examples 1 to 6 and Comparative Examples 1 to 6 were subjected to Cutting test 1 below to evaluate properties of the coated tools.

### Cutting test 1

Name of test: Wet drilling cutting test
Shape of drill: Cemented carbide drill with two cutting edges of a 6mm diameter
Shape of work material: A plate of carbon steel S50C
Cutting speed: 110 m/min.
Feed: 0.25 mm/rev
Depth of hole: 25 mm (blind hole machining)

The details of this cutting test 1 is as follows, and the results are shown in Table 6.

The drilling operation was repeated 4,000 cycles. If the flank wear width of the tip cutting edge surface reached 0.3 mm or if the cutting edge reached the end of its tool life due to chipping, fracture, or breakage before the end of the drilling operation, the drilling length was measured and the damage of the cutting edge was observed. Undamaged samples after the 4,000 cycles were subjected to measurement of the width of the flank wear.

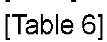

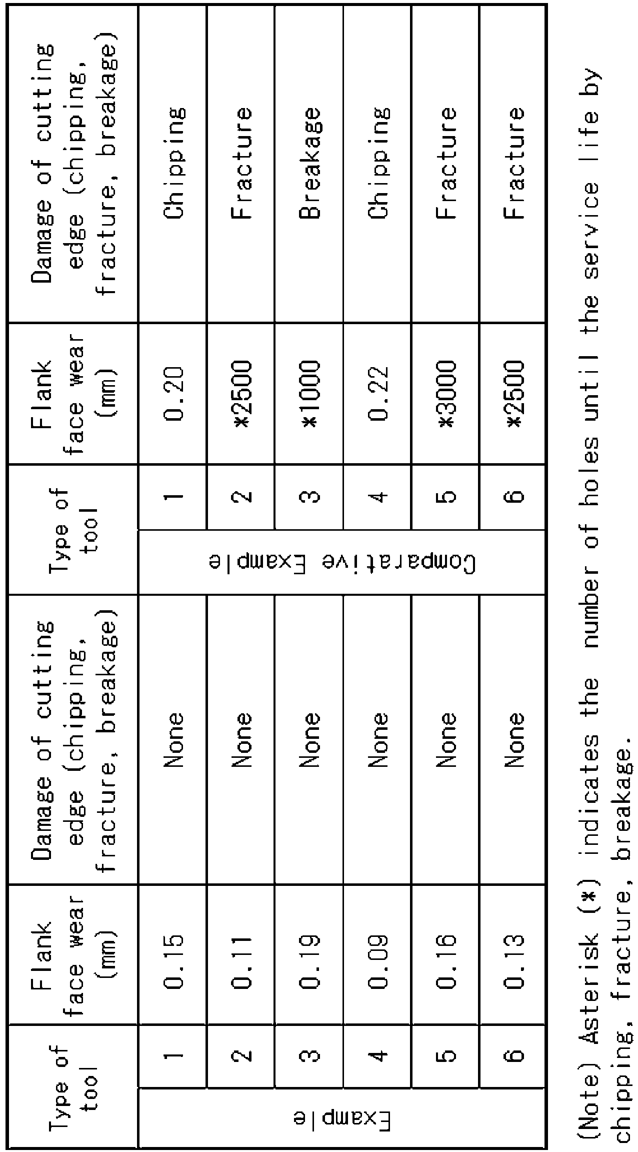

The cutting edge in Cutting test 1 (wet drilling test) comes into continuous contact with the work material during machining of each hole, and is detached from the work material between completion of a drilling cycle and the next drilling cycle; hence, Cutting test 1 can be categorized into high-load cutting that involves continuous cutting cycles and intermittent cutting cycles.

The results shown in Table 6 demonstrate that the tools of Examples each have a smaller amount of wear and longer life than the tools of Comparative Examples, and thus have improved wear resistance and chipping resistance under high-load cutting. In this embodiment, the substrate has a shape of a drill. However, these effects can be achieved regardless of the shape of the substrate under the same type of load applied to the cutting edge of the tool. For example, in the case of a substrate having a shape of an insert, similar improvements in cutting performance can be achieved in high-load cutting including continuous machining and intermittent machining, such as machining of round bars with holes and round bars with grooves.

### <Example B>

Examples (including examples with no third sublayer and/or no fifth sublayer) corresponding to embodiments will now be described, where a coated tool includes a coated layer having a laminated structure including a first sublayer, a second sublayer, a third sublayer, a surface sublayer (fourth sublayer), and an intermediate sublayer (fifth sublayer) as shown in FIG.3.

The same substrates as in Example A (shown in Table 1) were prepared, and the deposition conditions for the first to third sublayers were as shown in Table 2 according to Example A.

After the first to third sublayers were deposited, an optional intermediate sublayer (fifth sublayer) was deposited, and then a surface sublayer (fourth sublayer) was deposited to give Examples 11-24 shown in Tables 11 and 12.

In Examples 17 to 24, only the first and second sublayers, or only the first, second, and third sublayers were embodiments according to the present invention.

The intermediate sublayer (fifth sublayer) was formed by applying a predetermined current between the Al-Cr-Si alloy target and the anode shown in Table 7 under the deposition conditions shown in Table 7 to generate another arc discharge and by applying a predetermined current between the Ti-Si-W alloy target shown in Table 7 and the anode to generate another arc discharge , at the same time. A repeated variation in the Si content were formed in this intermediate sublayer (fifth sublayer). In Examples 23 and 24, no intermediate sublayer was formed, and a surface sublayer (fourth sublayer) was formed directly on the first or third sublayer.

The surface sublayer (fourth sublayer) was formed by arc discharge simultaneously between one or two Ti-Si-W alloy targets with different compositions shown in Table 8 and the anode(s) under the deposition conditions shown in Table 8. This surface sublayer (fourth sublayer) had a repeated variation in W content.

The deposition conditions of each layer were adjusted such that the full width at half maximum of the 111 diffraction peak and the ratio I₁₁₁/I₂₀₀, which were assigned to the first, second, and third sublayers were controlled to predetermined values. The results are shown in Table 11.

For comparison, the first to third sublayers (including the case that the topmost layer was a first sublayer not the third sublayer) were deposited on Drill substrates 1 to 3 under the deposition conditions shown in Table 3 as in Comparative Examples 1 to 6. A coating layer including a surface sublayer (fourth sublayer) and an intermediate sublayer (fifth sublayer) was then deposited under the conditions shown in Tables 9 and 10 to give Comparative Examples 11 to 16 shown in Tables 13 and 14.

The X-ray diffractometric results of Example 14 are shown in FIG. 5. A 111 diffraction peak of the surface sublayer (fourth sublayer) was observed between 36 and 37 degrees and the 200 diffraction peak of the same layer between 42 and 43 degrees, in addition to the diffraction peaks shown in FIG. 4.

The average thickness, the average composition, the repeated variation in Si content, and the repeated variation in W content of each layer were determined as in Example A. It was also confirmed similarly that the first to fifth sublayers contained crystal grains of NaCl-type face-centered cubic structure.

The surface sublayers (fourth sublayers) in Example 20 and Comparative Example 14 each have a substantially constant W content along the thickness of the surface sublayer (fourth sublayer) with no repeated variation in W content. The intermediate sublayer (fifth sublayer) in Comparative Example 11 has a substantially constant Si content along the thickness of the intermediate sublayer (fifth sublayer) with no repeated variation in Si content. The surface sublayer (fourth sublayer) of Example 20 and Comparative Example 14 were each formed with a single Ti-Si-W alloy target, like the surface sublayers (fourth sublayers) of Examples 11, 12, 14, and 16. However, the system temperature and the absolute bias voltage were high, and the N₂ gas pressure was low compared to these examples, hence, no a repeated variation were formed.

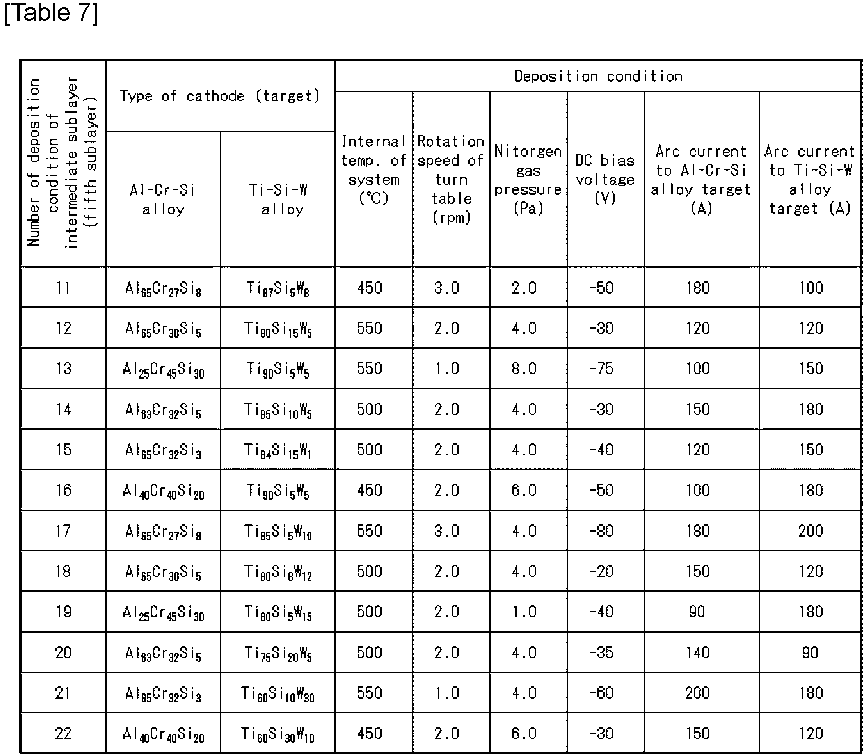

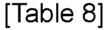

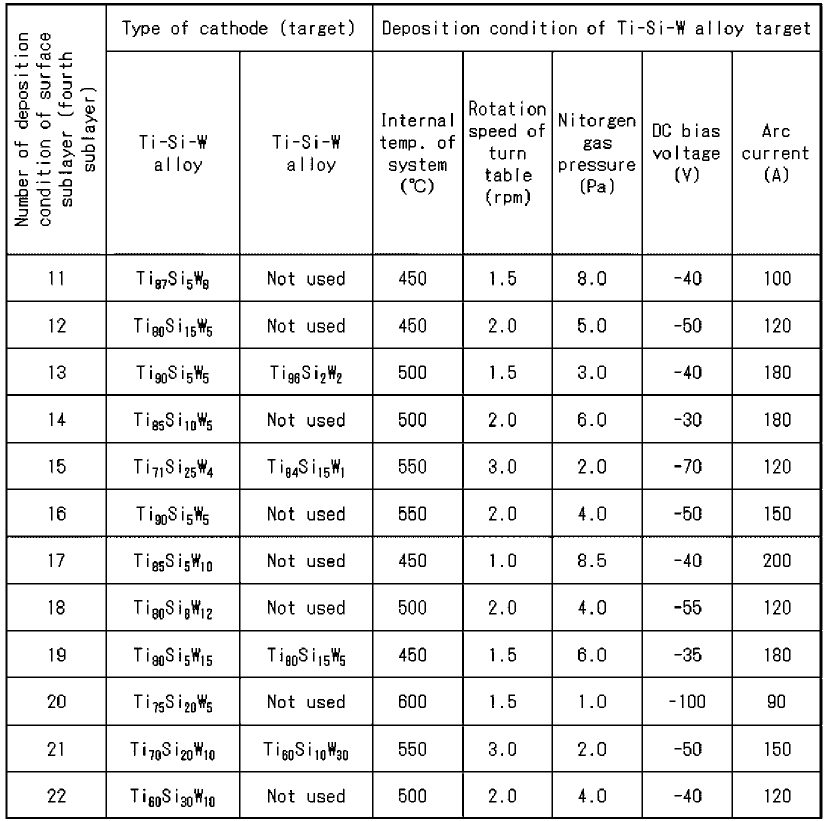

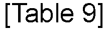

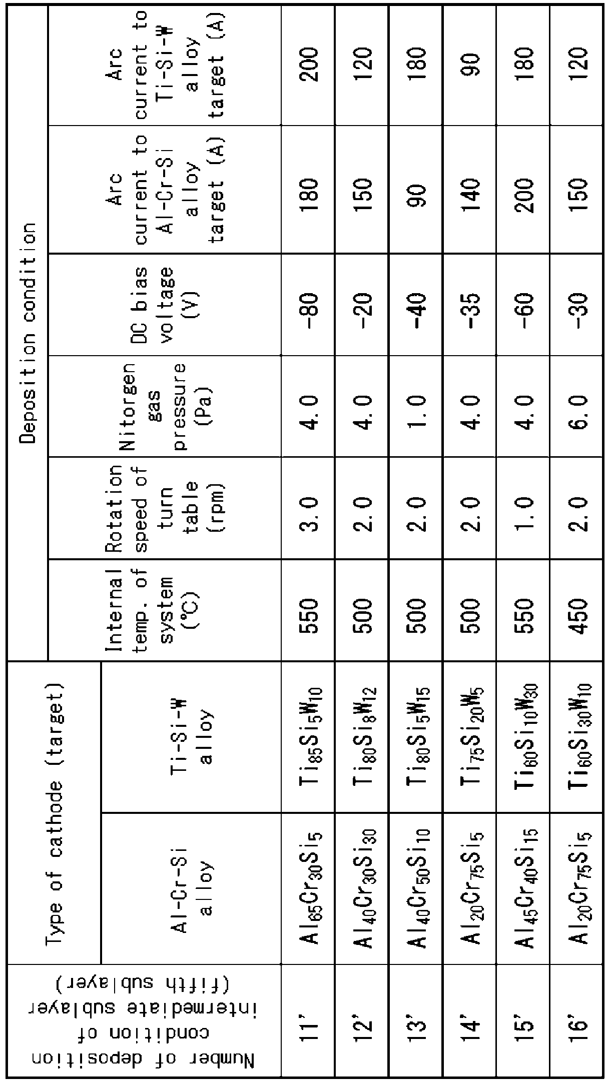

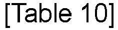

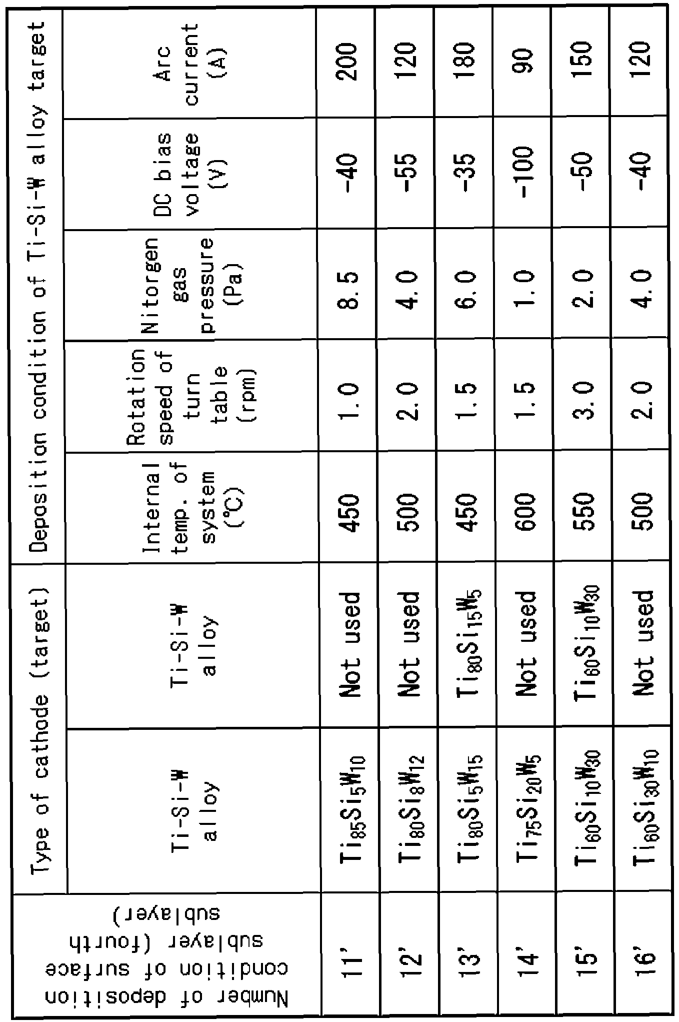

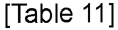

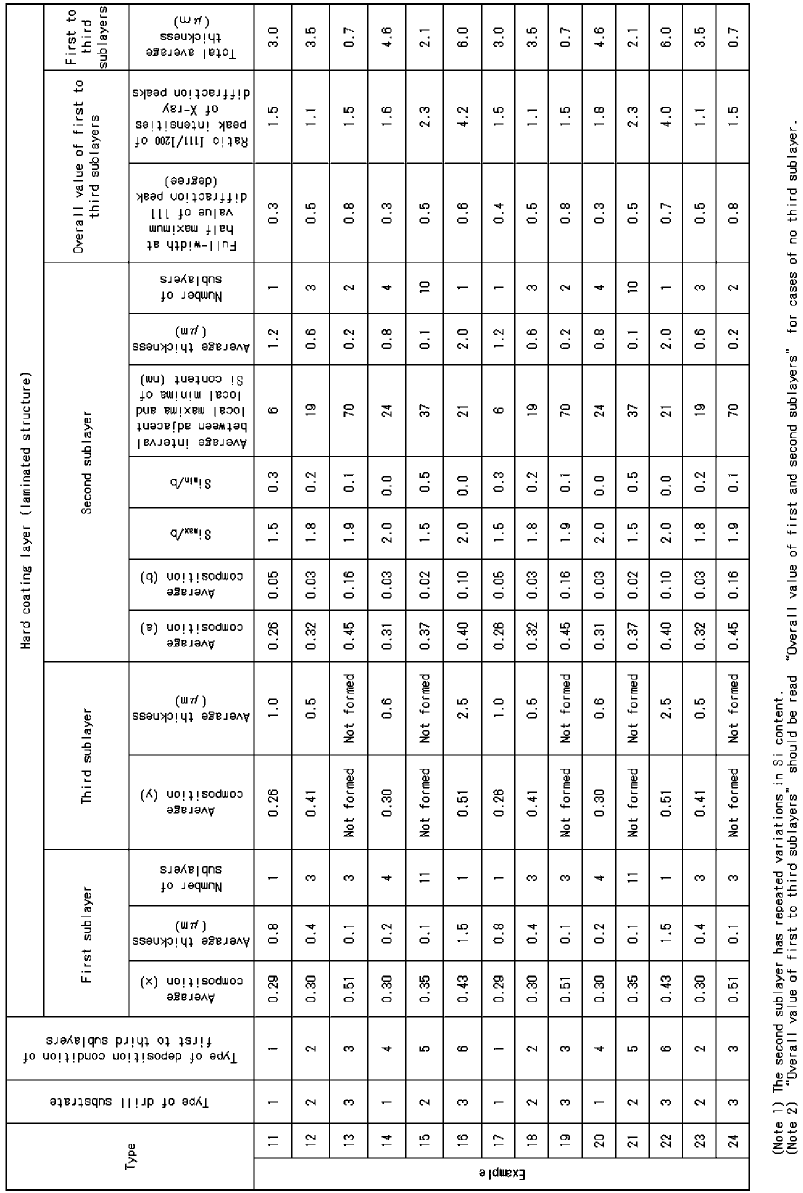

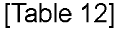

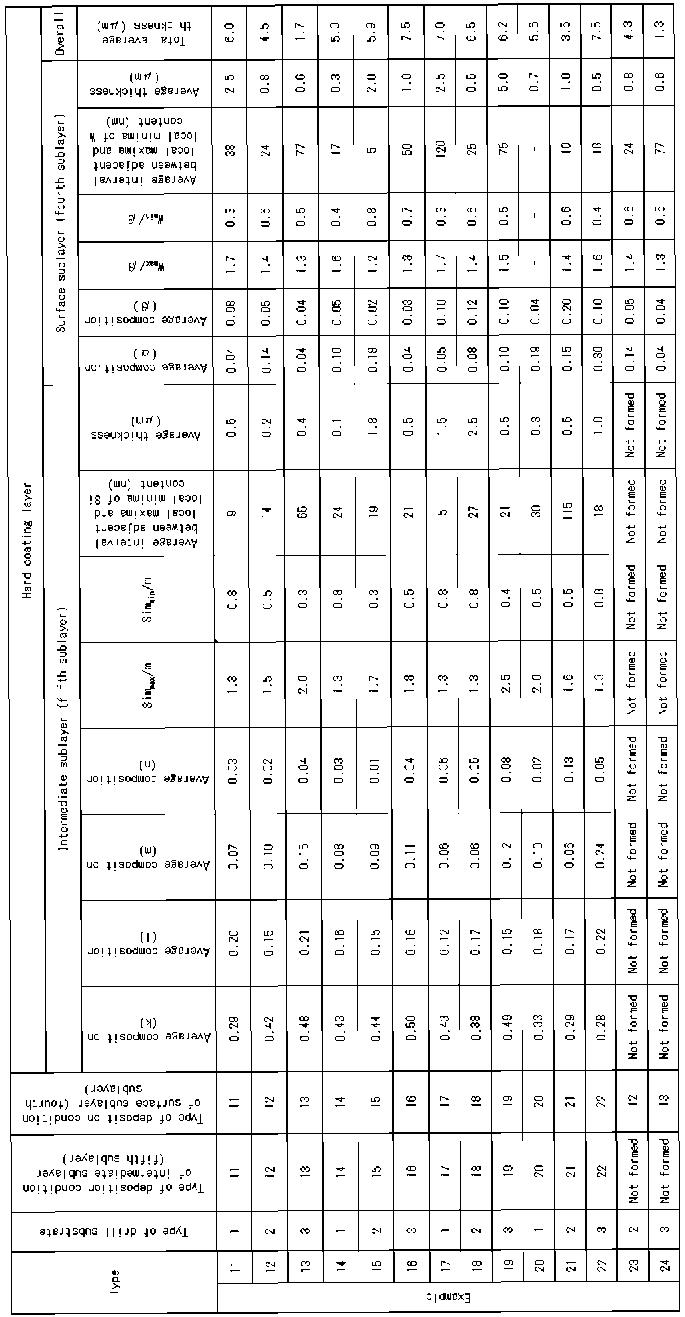

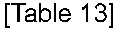

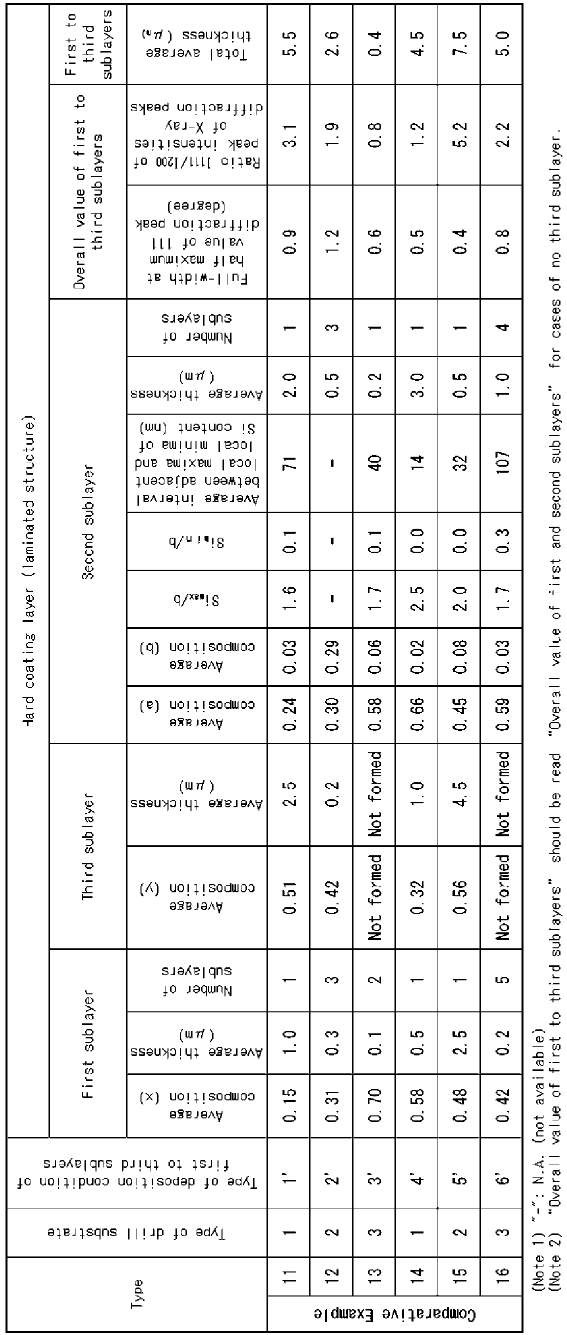

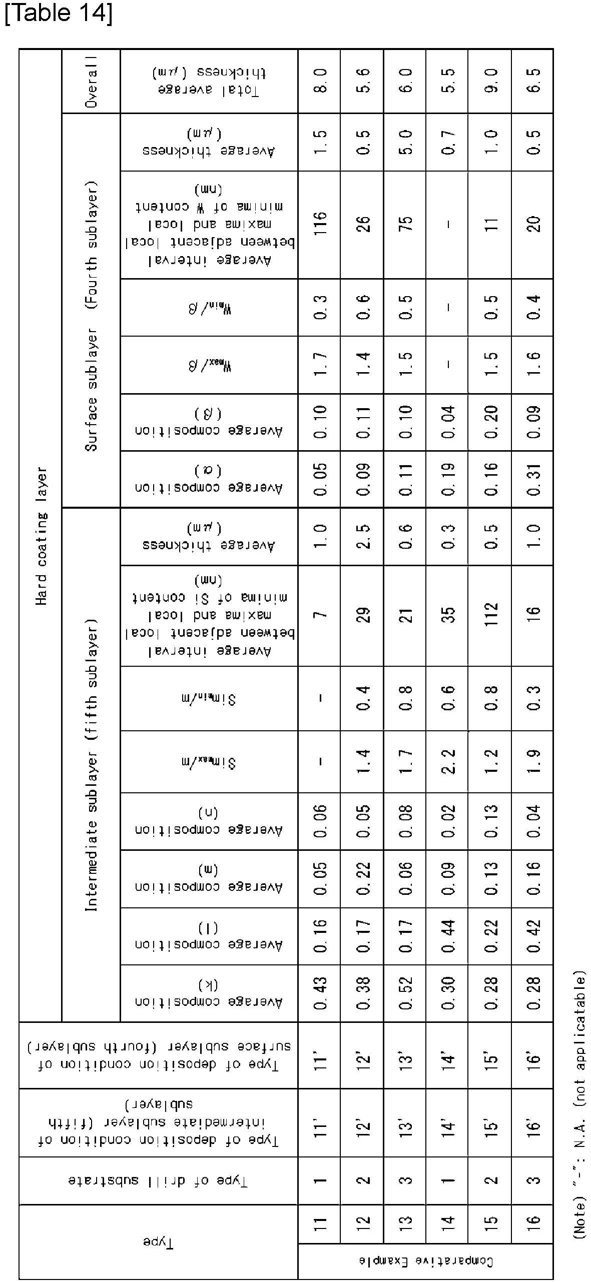

The sample of Examples 11 to 24 and Comparative Examples 11 to 16 were subjected to Cutting test 1 as in Example A to evaluate the properties of the coated tools. Table 15 shows the results.

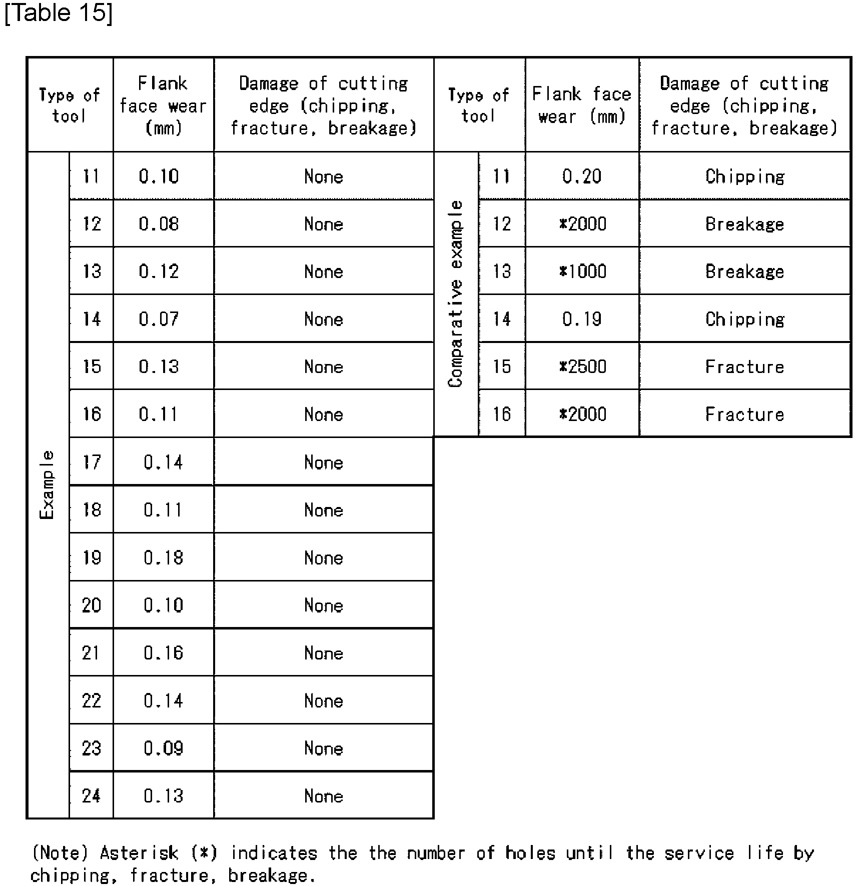

Based on the results of Table 15, Examples 2 to 6 and Examples 12 to 16 having only the first to third sublayers formed under the same deposition conditions were compared. A combination of the first to third sublayers with the fourth and fifth sublayers further improves the wear resistance and the chipping resistance under high-load cutting operations. Although the cutting tool of Example 1 includes a coating layer having a larger average thickness compared with that of Example 11, the amount of the flank wear of Example 11 is smaller than that of Example 1. This fact demonstrates that a combination with the fourth and fifth sublayers improves the wear resistance.

The coated tools of Examples 11 to 16 and Comparative Examples 11 to 16 were subjected to Cutting test 2 that was similar to that in Example A to evaluate the properties of each coated tool. The results are shown in Table 16.

### Cutting test 2

Name of test: Wet drilling cutting test
Shape of drill: Cemented carbide drill with two cutting edges of a 6mm diameter
Shape of work material: A plate of carbon steel S50C
Cutting speed: 125 m/min.
Feed: 0.25 mm/rev
Depth of hole: 30 mm (through-hole machining)

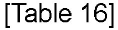

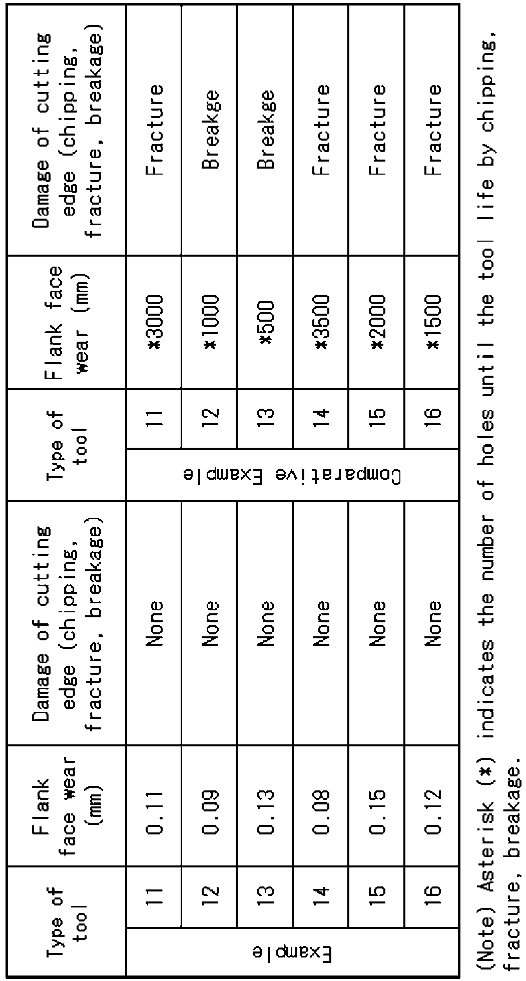

Even though Cutting test 2 (wet drilling test) is a high-load cutting operation similar to the cutting test 1 of Example A, it involves through-hole drilling under a higher cutting speed and a larger number of impacts. Cutting test 1 is accordingly a test under a higher load than Cutting test 1. The results in Table 16 demonstrates that the tools of Example B each have a smaller amount of wear and a longer life than the tools of Comparative Examples, and has higher wear resistance and higher chipping resistance even in cutting operations under a higher load than Cutting Test 1 of Example A. Example B employs drill substrates, like Example A. Similar effects will be achieved regardless of the shape of the substrate under the same type of load applied to the cutting edge of the tool. For example, in the case of a substrate having a shape of an insert, similar advantageous effects can be achieved in high-load cutting including continuous machining and intermittent machining, such as machining of round bars with holes and round bars with grooves.

The disclosed embodiments are merely examples in all respects and are not restrictive. The scope of the present invention is indicated by the scope of the claims rather than the above-described embodiments, and is intended to include meanings equivalent to the scope of the claims and all modifications within the scope.

### [Reference Sign List]

1 Substrate
2 First sublayer
3 Second sublayer
4 Third sublayer
5 Surface sublayer (fourth sublayer)
6 Intermediate sublayer (fifth sublayer)
7 Laminated structure
8 Anode
9 Ti-Si-W alloy target for fourth sublayer deposition (or Al-Cr alloy target for third sublayer deposition)
10 Ti-Si-W alloy target for fourth sublayer deposition
11 Al-Cr-Si alloy targets for second sublayer deposition and fifth sublayer deposition
12 Ar-Cr alloy target for first sublayer deposition
13 Heater
14 Turn table
15 Substrate
16 Reaction gas inlet
17 Exhaust gas port
18 Arc power supply
19 Bias power supply

## Claims

1. A surface-coated cutting tool comprising a substrate and a coating layer on the substrate; wherein
1) the coating layer has an average thickness of 0.5 µm or more and 8.0 µm or less, and has a laminated structure comprising one or more first sublayers and one or more second sublayers alternately deposited;
2) both a topmost sublayer and a bottommost sublayer of the laminated structure of the cutting tool are two of the first sublayers;
3) each of the first sublayers has an average thickness of 0.1 µm or more and 2.0 µm or less and has an average composition represented by (Al₁₋ₓCrₓ)N (where 0.20 ≤ x ≤ 0.60);
4) each of the second sublayers has an average thickness of 0.1 µm or more and 2.0 µm or less, has an average composition represented by (Al_{1-a-b}CrₐSi_{b})N (where 0.20 ≤ a ≤ 0.60 and 0.01 ≤ b ≤ 0.20), and has a repeated variation in Si content such that the average interval between local maxima and adjacent local minima is 1 nm or more and 100 nm or less; and the Si content has an average Siₘₐₓ of the local maxima satisfying the expression: 1.0 < Siₘₐₓ/b ≤ 2.0 and an average Siₘᵢₙ of the local minima satisfying the expression 0.0 ≤ Siₘᵢₙ/b < 1.0;
5) both the first sublayers and the second sublayers comprise crystal grains of a NaCl-type face-centered cubic structure; and
6) the overall coating layer comprising the first sublayers and the second sublayers has a combined 111 X-ray diffraction peak with a full width at half maximum of 0.1 degrees or more and 1.0 degrees or less and a peak intensity I₁₁₁ and has a combined 200 X-ray diffraction peak with a peak intensity I₂₀₀, where the ratio I₁₁₁/I₂₀₀ is greater than 1.0 and less than 5.0.

2. The surface-coated cutting tool of claim 1, wherein the topmost first sublayer of the laminated structure of the tool is replaced with a third sublayer that has an average composition represented by (Al_{1-y}Cr_{y})N (where 0.20 ≤ y ≤ 0.60) and has an average thickness of 0.3 µm or more and 4.0 µm or less, and the average thickness of the third sublayer is larger than that of the other first sublayers of the laminated structure.

3. The surface-coated cutting tool of claim 1 or 2, wherein the coating layer further comprises a surface layer on the topmost first or third sublayer, the surface sublayer having an average thickness of 0.1 µm or more and 4.0 µm or less and an average composition represented by (Ti_{1-α-β}Si_{α}W_{β})N (where 0.01 ≤ α ≤ 0.20 and 0.01 ≤ β ≤ 0.10); and
the surface sublayer has a repeated variation in W content such that the average interval between local maxima and adjacent local minima is 1 nm or more and 100 nm or less, and the W content has an average Wₘₐₓ of the local maxima satisfying the expression: 1.0 < Wₘₐₓ/β ≤ 2.0 and an average Wₘᵢₙ of the local minima satisfying 0.0 ≤ Wₘᵢₙ/β ≤ 1.0.

4. The surface-coated cutting tool of claim 3, wherein the coating layer further comprises an intermediate layer between the first or third sublayer and the surface sublayer of the laminated structure, the intermediate layer having an average thickness of 0.1 µm or more and 2.0 µm or less and an average composition represented by (Al₁₋ₖ₋ₗ₋ₘ₋ₙTiₖCrₗSiₘWₙ)N (where 0.20 ≤ k ≤ 0.65, 0.10 ≤ l ≤ 0.35, 0.00 < m ≤ 0.15, and 0.00 < n ≤ 0.05); and
the intermediate sublayer has a repeated variation in Si content such that the average interval between local maxima and local minima is 1 nm or more and 100 nm or less, and the Si content has an average Simₘₐₓ of the local maxima satisfying the expression: 1.0 < Simₘₐₓ/m ≤ 2.0 and an average Simₘᵢₙ of the local minima satisfying the expression 0.0 ≤ Simₘᵢₙ/m < 1.0.
